Europäisches Patentamt

(19) European Patent Office

Office européen des brevets

(11) Publication number: **0 330 152**

**A2**

(12) **EUROPEAN PATENT APPLICATION**

(21) Application number: **89103014.0**

(22) Date of filing: **21.02.89**

(51) Int. Cl.⁴: **H01L 33/00 , H01S 3/18 , C30B 23/02**

(30) Priority: **23.02.88 JP 41661/88**
**23.02.88 JP 41662/88**

(43) Date of publication of application:
**30.08.89 Bulletin 89/35**

(84) Designated Contracting States:
**DE FR GB IT**

(71) Applicant: **Sukegawa, Tokuzo**
**23-7, Shijimizuka 3-chome**
**Hamamatsu-shi Shizuoka, 432(JP)**

Applicant: **Mitsubishi Cable Industries, Ltd.**
**8, Nishinocho Higashimukoujima**
**Amagasaki-shi Hyogo 660(JP)**

(72) Inventor: **Sukegawa, Tokuzo**
**23-7, Shijimizuka 3-chome**
**Hamamatsu-shi Shizuoka, 432(JP)**
Inventor: **Tadatomo, Kazuyuki**
**Itami Plant of Mitsubishi Cable Industries, Ltd.**
**3, Ikejiri 4-chome Itami-shi Hyogo, 664(JP)**
Inventor: **Ito, Akira**
**Itami Plant of Mitsubishi Cable Industries, Ltd.**
**3, Ikejiri 4-chome Itami-shi Hyogo, 664(JP)**

(74) Representative: **von Kreisler, Alek,**
**Dipl.-Chem. et al**
**Patentanwälte Von Kreisler-Selting-Werner**
**Deichmannhaus am Hauptbahnhof**
**D-5000 Köln 1(DE)**

(54) Semicondustor light emitting device.

(57) The semiconductor light emitting device is a light emitting diode (LED) or laser diode (LD) composed of a substrate composed of III-V group elements and GaInP system mixed crystal of III-V group mixed crystal, which comprises a III-V group substrate, a first layer mainly composed of GaInP being formed on this III-V group substrate by the yo-yo solute feeding method or Sn solvent method, and a second layer mainly composed of GaInP being formed on the first layer by a method selected from MOVPE, MBE and LPE, thereby obtaining short wavelength emission in green to yellow color.

## SEMICONDUCTOR LIGHT EMITTING DEVICE

### Background of the Invention

#### 1. Field of the Invention

This invention relates to a semiconductor light emitting device such as light emitting diode (LED) and laser diode (LD) comprising a substrate composed of III-V group elements (hereinafter called a III-V group substrate) and GaInP mixed crystals mainly composed of GaInP of III-V group mixed crystals,namely, alloy crystal comprising at least Ga, In and P.

#### 2. Description of the Prior Art

The GaInP system mainly composed of GaInP which is a ternary alloy compound semiconducting material of III-V group possesses the largest direct transition type band gap in the III-V group compound semiconductor mixed crystals except for nitrides, and is the most advantageous material for constituting a light emitting device which emits not only red waves but also green and yellow waves, and is presently used as the material for red LED and LD.

Accordingly, as shown in Fig. 10, green and yellow short wavelength light emission will be realized by fabricating a light emitting device having a structure composed of a III-V group substrate 200, a GaInP system first layer 210 mainly composed of GaInP as the buffer layer for lattice matching, and a GaInP system second layer 220 mainly composed of GaInP.

Various attempts have been made to obtain a light emitting device in the structure shown in Fig. 10, and the most highly expected example is to laminate the GaInP system second layer 220 by MOVPE (metal organic vapor phase epitaxy) on the GaAs substrate used as the III-V group substrate 200 (in this case, the first layer 210 for lattice matching is not necessary).

In this attempt, however, due to restrictions of lattice matching of the second layer 220 with GaAs, red waves are emitted when the light emitting region is made of GaInP. In order to shorten the wavelength of emitted light in green to yellow waves in this system, it is needed to form the light emitting region by AlGaInP containing Al, and due to the presence of Al which is likely to be oxidized, the reliability and performance of the light emitting device are lowered.

Moreover, in the prior art, by employing as a substrate a III-V group substrate 200, such as a GaAs or GaP substrate which has thereon a GaPAs grown layer (the first layer 210 in Fig. 10) for lattice matching and by growing the GaInP second layer 220 on the above substrate having GaPAs grown layer under lattice matching condition, it is possible to emit yellow to green waves using AlGaInP low in Al content or GaInP without containing Al as the light emitting region.

The above substrate is usually fabricated in vapor phase growth, but because of the surface morphology of peculiar cross-hatch pattern, the surface morphology can be hardly improved if multiple layers are formed on it, and a flat interface cannot be obtained. Besides, multiple misfit dis locations of high density occur, and when LED or LD is fabricated, the reliability and performance are extremely spoiled.

### Summary of the Invention

It is hence a primary object of this invention to present a semiconductor light emitting device capable of emitting short wavelength light in green to yellow, in a semiconductor comprising a III-V group substrate and first and second layers of GaInP system mixed crystal mainly composed of GaInP as shown in Fig. 10.

To achieve the above object, the semiconductor light emitting device of this invention comprises a substrate composed of III-V group elements, a first layer mainly made of GaInP formed on this III-V group substrate by yo-yo solute feeding method or Sn solvent method, and a second layer mainly composed of GaInP formed on the first layer by a method selected from MOVPE, MBE, and LPE.

In the light emitting device of this invention, a GaInP system (such as GaInP, AlGaInP, and GaInPAs) mixed crystal or GaInP alloy crystal can be grown as the first layer on the III-V group (such as GaP, GaAs and InP) substrate by yo-yo solute feeding method or Sn solvent method, and by laminating a GaInP system mixed crystal on the first layer as the second layer (acting as cladding layer, active layer and so on) by a method selected from the known MOVPE, MBE and LPE, short wavelength emission in green to yellow light is obtained.

The above-mentioned yo-yo solute feeding method and Sn solvent method are both processes for forming a layer of solid solution mainly composed of GaInP on a semiconductor substrate by LPE method. The detailes of both processes are mentioned later. Incidentally, in the Sn solvent method, as a result of using the Sn solvent, the content of Sn doped in the first layer of the GaInP system mixted crystal is about $10^{17}$ to $10^{19}/cm^3$, or preferably about $10^{18}/cm^3$.

The method of growing the second layer of GaInP mixed crystal on the GaInP system first layer formed by yo-yo solute feeding method or Sn solvent method is selected from the known MOVPE (metal organic vapor phase epitaxy), MBE molecular beam epitaxy) and LPE (liquid phase epitaxy).

The III-V group substrate in this invention is not particularly limited as far as it is a compound semiconductor crystal substrate composed of at least one element in column III and at least one element in column V in the Periodic Table, and in particular, GaP substrate, GaAs substrate and InP substrate are desired. The first layer and second layer of GaInP system mixed crystal to be laminated on the III-V group substrate are not particularly limited as far as they contain at least Ga, In and P, and a device thus obtained can emit short wavelength light in green to yellow, and for example, GaInP, AlGaInP and GaInPAs may be used.

Brief Description of the Drawings

Fig. 1 is a sectional view showing an example of a light emitting element formed by yo-yo solute feeding method in the semiconductor light emitting device of this invention,

Fig. 2 is a sectional view showing other example of a light emitting element formed by yo-yo solute feeding method in the semiconductor light emitting device of this invention,

Fig. 3 is a sectional view showing an example of a light emitting element formed by the Sn solvent method in the semiconductor light emitting device of this invention,

Fig. 4 is a sectional view showing other example of a light emitting element formed by the Sn solvent method in the semiconductor light emitting device of this invention,

Fig. 5 (a) - (e) are drawings for explaining the yo-yo solute feeding method which is a fabrication method for forming GaInP layer on GaP substrate in the constituent materials of the light emitting device shown in Figs. 1 and 2,

Fig. 6 is a schematic sectional view showing an example of sliding boat used in fabrication of a light emitting device according to the explanation shown in Fig. 5 (a) to (e).

Fig. 7 is a graph showing the relation between the composition ratio of GaP in the GaInP mixed crystal and the lattice constant of the GaInP mixed crystal corresponding to that composition, in forming Sn doped GaInP layer on GaAs substrate by the Sn solvent method in the constituent materials of the light emitting element shown in Figs. 3 and 4,

Fig. 8 is a sectional view of an example of a semiconductor light emitting device of the present invention built in the structure shown in Fig. 1,

Fig. 9 is a sectional view of an example of a semiconductor light emitting device of the present invention built in the structure shown in Fig. 1 or Fig. 3, and

Fig. 10 is a basic structural sectional view of a light emitting element capable of emitting short wavelength light in green to yellow, comprising a III-V group substrate and GaInP system first and second layers.

Detailed Description of the Invention

The semiconductor light emitting device of this invention is described in details below while referring to some of the embodiments thereof.

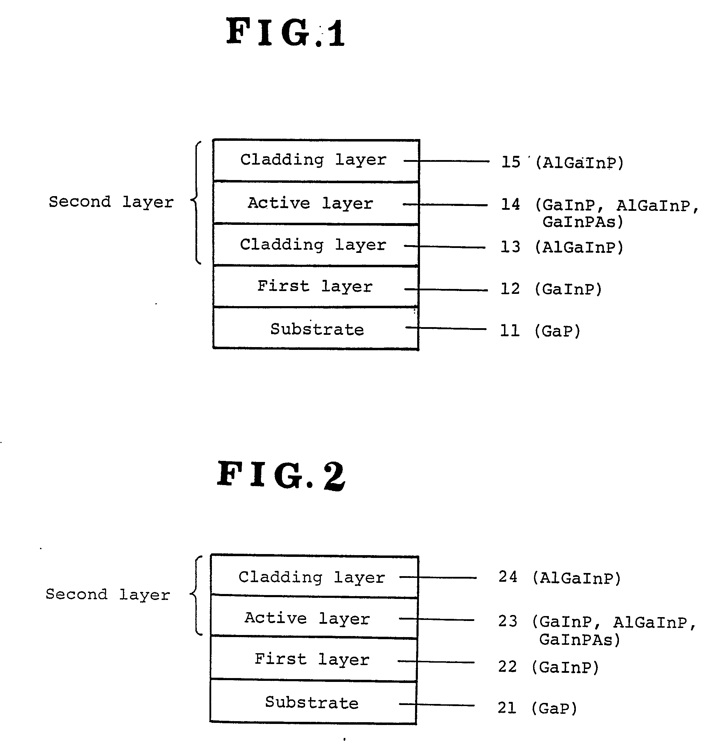

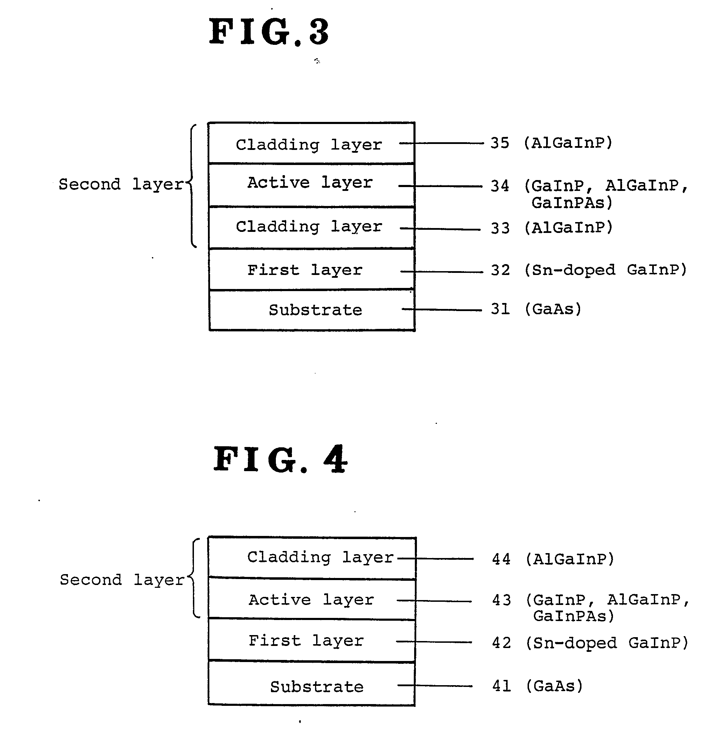

The structure of the light emitting element forming a GaInP system first layer on a III-V group substrate by the yo-yo solute feeding method is shown in Figs. 1 and 2, and the structure of the light emitting element forming a GaInP system first layer on a III-V group substrate by the Sn solvent method is given in Figs. 3 and 4.

Referring first to Fig.1, which is a basic structural drawing of a double hetero structure using a GaP substrate 11 as the substrate composed of III-V group elements, this light emitting element has a GaInP layer 12 which is the first layer of GaInP system mixed crystal formed on the GaP substrate 11 by the yo-yo solute feeding method, and as the second layer of GaInP mixed crystals, multiple layers having double hetero junction, that is, AlGaInP cladding layer 13, GaInP (or AlGaInP, GaInPAs) active layer 14, and AlGaInP cladding layer 15 are sequentially grown epitaxially on the GaInP layer 12.

Fig. 2 shows a light emitting element in single hetero structure using a GaP substrate 21, in which a GaInP layer 22 is formed as the first layer on the GaP substrate 21 by the yo-yo solute feeding method, and as the second layer, multiple layers having single hetero junction, that is, GaInP (or AlGaInP, GaInPAs) active layer 23 and AlGaInP cladding layer 24 are sequentially grown epitaxially on the GaInP layer 22. In the present invention, since there is generally a large mismatching in the lattice constant between the substrate and the first layer, it is desired to set the thickness of the first layer, that is, the GaInP layer, greater in order to lessen the effects of distortion and dislocation caused by the large mismatching.

In the light emitting devices shown in Figs. 1 and 2, the yo-yo solute feeding method for growing the first layer of GaInP on the GaP substrate is carried out in the following manner.

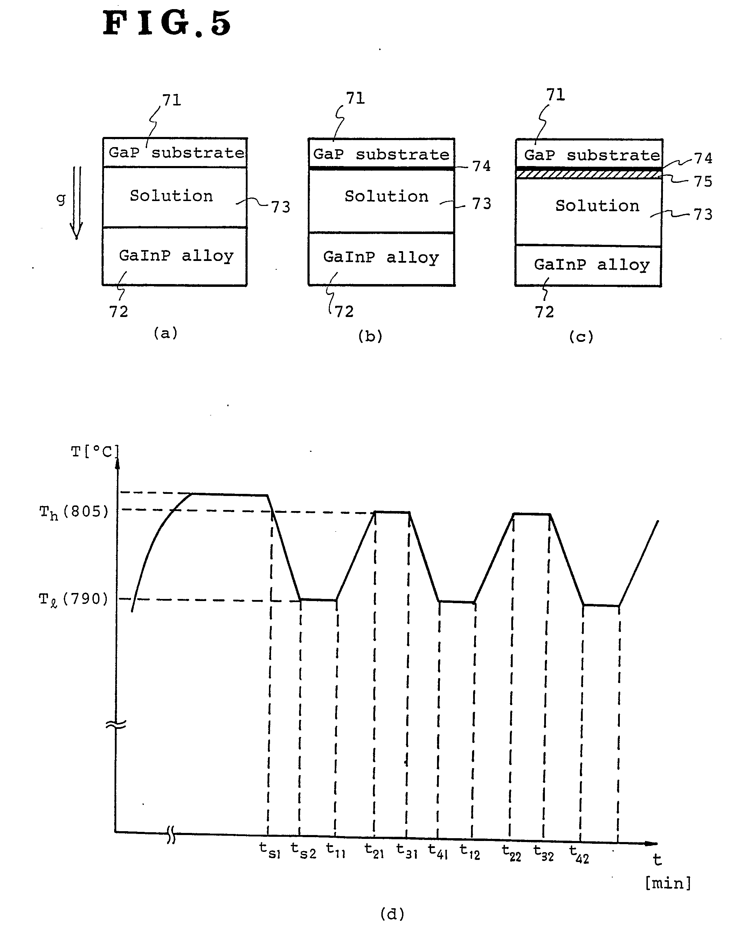

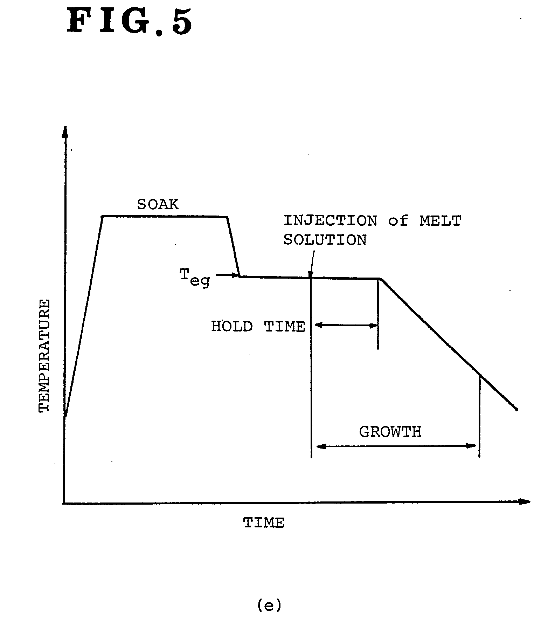

In the method of employing the yo-yo solute feeding method in Fig. 5, there may be used as a GaP substrate 71, one which has a GaInP mixed crystal layer having a desired composition directly grown on a usual GaP substrate 71 by MOVPE, MBE or LPE.

As shown in Fig. 5 (a), when LED etc. of green waves emission is desired, the GaP substrate 71 is disposed at the upper side, and the GaInP alloy 72 of which composition has a GaP molar fraction of 0.73 is disposed at the lower side. This GaP substrate (71) has an area of 1 x 1 cm$^2$, crystal orientation of (100), (111)B or (111)A (having just facet or an off angle, preferably having an off angle of about 0.5 -10 degrees, more preferably, 1 - 5 degrees), and carrier concentration of $10^{17}$ to $10^{19}$/cm$^3$. At this time, not to mention, the surface of the GaP substrate has been polished, and is sufficiently cleaned by using proper etchant and rinse. The GaInP alloy is obtained in the following preparation methods. One is the method of pulverizing GaP and InP crystals, blending so that the GaP molar fraction may be 0.73, and sintering in a vacuum sealed quartz ampule for 24 hours at about 1070°C. It can also be obtained by the method of melting the materials at the molar ratio of InP : GaP = 27 : 73 at 1450°C or higher temperature using a high pressure furnace so as to prevent individual dissociation, sufficiently unifying the composition of this InP-GaP pseudobinary solution, and cooling quickly to solidify. The solution to be used is adjusted to precipitate a solid solution of 0.75 to 1.0, or more preferably 0.8 to 0.95 as the molar fraction of GaP, at 700 to 1000°C, or more preferably at 750 to 850°C.

Practically, for example, in order to precipitate a solid solution of 0.84 as the molar fraction of GaP at $T_{eq}$ [810°C, see Fig. 5 (d)], a solution having 9.43 mg of InP and 92.48 mg of GaP dissolved in 5 g of In is used. This solu tion with even more, excellent uniformity can be prepared, for example, by the method of dissolving the GaP, InP crystals in In solvent at 1000°C, stirring for 24 hours, and then cooling quickly. In this way, GaP substrate 71, GaInP alloy 72 and solution 73 are prepared. Heating the In-Ga-P solution corresponding to the solid solution at the GaP molar fraction of 0.84, a temperature several degrees higher than 810°C (810°C + ΔT) is maintained constantly, and then cooling is started at a cooling rate of 0.05 - 5°C/min., or more preferably 0.2 -1°C/min. employed in the ordinary LPE. At this time, of course, the procedures are carried out under the surrounding atmosphere of high purity inert gas or $H_2$ gas. When the temperature becomes $T_h$ (805°C), that is, at time $t_{si}$ in Fig. 5 (d), the solution is inserted between the GaP substrate 71 and GaInP alloy 72. This state is shown in Fig. 5 (a). At this time, the thickness of the solution is about 500μm. In the diagram, the symbol g denotes the direction of gravity, and in order to obtain a flat growth, it is important that the GaP substrate 71 and GaInP alloy 72 are placed parallel and horizontal. When cooled down to $T_l$ (790°C) at the above cooling rate, the solution is supersaturated, but the growth of GaInP takes place mainly on the GaP substrate due to the difference in specific gravity. The GaP molar fraction of this mixed crystal composition is 0.84. Keeping at 780°C for 10 minutes from time $t_{s2}$ to $t_{11}$, the temperature is then raised to $T_h$ from time $t_{11}$ at a rate of 0.05 - 5°C/min, preferably at a rate of 0.2 - 1°C/min. At this time, the solution is gradually unsaturated, but the dissolution mainly occurs from the lower GaInP alloy 72 because of the effect of difference in the specific gravity. Since the composition of this GaInP alloy 72 has a GaP molar fraction of 0.73, the solution is somewhat deviated to the InP side. After holding at $T_h$ for 10 minutes from time $t_{21}$ to $t_{31}$, this cycle is repeated. By repeating this temperature cycle several times, the composition of the precipitating GaInP mixed crystal gradually approaches the GaP molar fraction of 0.73, and several times later the composition of the precipitating phase no longer varies. The state at this time is shown in Fig. 5 (b), in which numeral 74 denotes a GaInP relaxation layer in the first layer, and is composed of multiple layers in which the composition varies stepwise. By further repeating this temperature cycle for several times, the first layer of a desired thickness, namely, the GaInP layer with mixed crystal composition constant at GaP molar fraction of 0.73 may be grown corresponding to the number of repetitions of the temperature cycle. This state is shown in Fig. 5 (c), in which numeral 75 is the intended mixed crystal composition, that is, it shows the GaInP mixed crystal layer with the constant GaP molar fraction of 0.73. At the end of the growth, the GaP substrate 71 is left from the solution by sliding, or the entire structure of the GaP substrate 71, material GaInP alloy 72 and solution 73 is rotated to invert the vertical relation of the GaP substrate 71 and GaInP material alloy 72, so that it is essential to avoid an excessive precipitation on the GaP substrate at the time of cooling. Thus, by every repeat of the temperature cycle in this temperature process, the GaInP relaxation layers 74 of which the GaP molar fraction decreases about 0.012 are grown stepwise, and after 10 periods, the GaInP mixed crystal layer 75 of a desired thickness corresponding to the number of temperature cycles having the mixed crystal composition constant at the GaP molar fraction of 0.73 is grown. In the present embodiment, the first layer consists of the above-mentioned layers 74 and 75.

Shown next is another embodiment for forming the first layer by the yo-yo solute feeding method. In this embodiment, a first layer not containing the formation of the relaxation layer 74 is formed on a semiconductor substrate.

Hitherto, Y. Ohki, I. Asano and I. Akasaki et al. reported the growth of GaInP layer in a molar fraction range of 0.5 to 0.9 of GaP in composition by chloride VPE on the GaP(100) and (111)B substrate in J. Cryst. Growth, vol. 24/25, p. 224 (1974). Besides, S. Kondo, S. Matsumoto and H. Nagai et al. reported in Appl. Phys. Lett., vol. 53, No. 4, p. 25 (July 1988) that GaAs was first grown on the Si substrate by MOVPE, and then GaInP with a molar fraction of 0.5 of GaP in composition grown successively by MO-chloride VPE. As for LPE, however, J. Nishizawa and S. Yoshida et al. reported that the growth layer was not lamellar but was columnar ($Ga_{0.7}In_{0.3}P$, epitaxial layer with shape columnar grown on GaP substrate), when GaInP with molar fraction of 0.7 of GaP in composition was grown using GaP(111)B as a substrate in J. Cryst. Growth, vol. 78, pp. 274-278 (1986). By contrast, the present inventors discovered that a lamellar GaInP mixed crystal layer having a specified composition can be grown on the GaP substrate by the following procedure even by the LPE process.

Needless to say, when the crystal having GaInP layer grown on GaP is used as the substrate 71, it is possible to grow a GaInP layer 75 having a desired mixed crystal composition directly on this substrate without using a stepwise composition gradient layer 74.

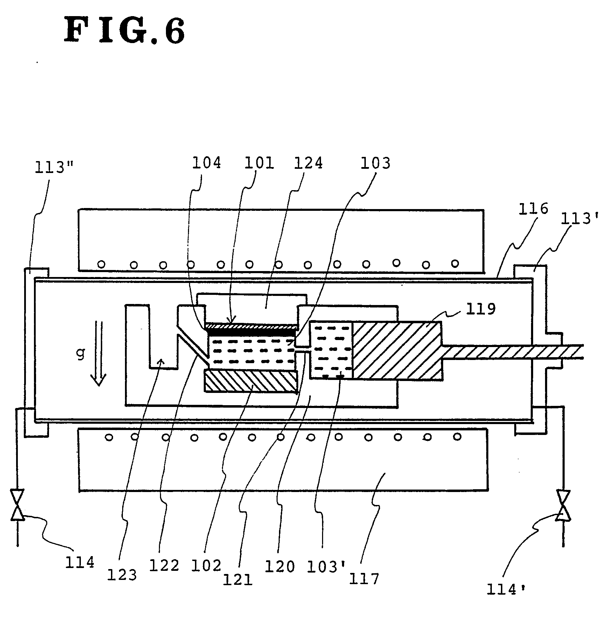

The method of directly growing the GaInP layer of desired composition on the GaP substrate by LPE is stated below while referring to the sliding boat shown in Fig. 6. In this drawing, 113', 113" are flanges, 114, 114' are valves for atmospheric gas, 116 is a quartz tube, 117 is an electric furnace, 121 is a growth solution lead-in hole, 122 is an excess solution discharge hole, and 123 is an excess solution tray.

This is an example of growing $In_{1-x}Ga_xP$ on the GaP(111)B plane as the seed crystal substrate (III-V group substrate). First, the GaP(111)B plane seed crystal substrate 101 cleaned by a known method is placed in a proper sliding boat, for example, at the upper side of the boat 120, and an $In_{1-x}Ga_xP$ material alloy 102 having a desired mixed crystal composition is disposed at the lower side. As this material alloy, GaP may be also used as described later. The composition of the growth solution 103 is adjusted to precipitate a solid solution of desired composition, and also to have a proper super-cooling at the growth starting temperature. These materials are charged into the boat 120, and a high purity hydrogen gas is passed into the growth system, and the atmosphere is sufficiently purified. In consequence, the temperature of this growth system is raised to a temperature slightly higher than the equilibrium temperature of the solution 103' as shown in Fig. 5 (e), and this temperature is held for a specific time, and the composition of the solution 103' is unified.

In this embodiment, since the atomic ratio of the solution 103' is so adjusted as to be In : Ga : P = 95 : 1.5 : 3.5 in order to obtain LED etc. of green wave emission and in order to make the solution 103' be equilibrium at 820°C, the homogenizing temperature of the solution is set at 850°C. Afterwards, the solution is cooled to the equilibrium temperature $T_{eq}$. This temperature may be set somewhat higher than the equilibrium temperature. Next, holding at this temperature, the solution is allowed to be stable. Practically, the temperature is kept at 820 to 825°C for 30 minutes to 2 hours, so that the In-Ga-P solution 103' charged in the cylinder may be sufficiently mixed uniformly. By operating the piston 119, the solution is charged into the space between seed crystal 101 and material alloy 102, and this temperature is kept for 30 to 60 minutes, thereby sufficiently reaching the thermal equilibrium at the solid-liquid interface between the seed crystal 101 and solution for growth 103. Afterwards, by gradually cooling at a proper rate, for example, 0.1 to 0.5°C/min, first nuclei are epitaxially formed on the seed crystal substrate, and then lateral growth is effected to obtain a desired mixed crystal composition, for example, an initial growth layer of $Ga_{0.73}In_{0.27}P$, on the GaP substrate. As a practical example of growth, by cooling from 823 to 818°C at a rate of 0.5°C/min and then from 818 to 790°C at a rate of 0.2°C/min, an initial growth layer of $Ga_{0.7}In_{0.3}P$ in a thickness of 3 to 5 $\mu$m could be grown on the GaP substrate. This slow cooling was effective for promoting the lateral growth. The foregoing temperature program, however, is only an example, and the initial growth layer can be obtained, needless to say, by other method.

After forming the initial growth layer in this manner, the temperature is kept at 790°C ($T_1$) for about 20 minutes, and then the similar temperature process as shown in Fig. 5 (d) is started, that is, the temperature process from time $t_{11}$. Specifically, for example, from $T_1$ = 790°C, the temperature is raised to $T_h$ = 805°C at a rate of 0.3 to 0.8°C/min, and after holding this temperature for 20 to 30 minutes, it is gradually cooled to 790°C at a rate of 0.3 to 1°C/min, and this temperature is held for 20 minutes to finish one cycle. This temperature cycle was repeated. After 30 cycles, a favorable $Ga_{0.7}In_{0.3}P$ layer in thickness of 200 $\mu$m could be grown.

In the foregoing explanation, the GaP(111)B plane of the seed crystal substrate was used, but this invention may be also embodied in other orientation, for example, the (100) plane. As the material alloy, a desired GaInP mixed crystal composition may be used. For example, when GaP is used as the material alloy, by properly setting the temperature rampping process and temperature cooling process, it is possible to grow GaInP mixed crystal having a desired composition by matching the amount of dissolution of GaP from the material alloy into the solution 103, and the amount of GaP contained in the grown GaInP mixed crystal.

In the yo-yo solute feeding method, since the solute in the In-Ga-P solution is always receiving an upward force due to the difference in the specific gravity, the growth at the GaInP alloy side may be almost ignored, and the growth takes place mostly on the GaP substrate at the upper side. After keeping at a specific temperature for a certain time, the temperature is elevated at a specific rate up to the growth initiating temperature. In this process, the solution becomes gradually unsaturated, but since the solution nearly reaching the saturation by the dissolution from the GaInP alloy is quickly transferred to the vicinity of the upper GaP substrate by the difference in specific gravity, the state of saturation is maintained even in the process of temperature elevation in the vicinity of the GaP substrate, so that melt-back from the GaP substrate does not occur. After keeping this temperature for a specific time, cooling is started again. By repeating such temperature cycle, the GaInP mixed crystal can be grown on the GaP substrate, by using GaInP alloy as the material.

That is, the yo-yo solute feeding method makes use of the phenomenon that the field of gravity and the specific gravity of solution depend on the concentration of the solute contained in the solution, and it is so named because the temperature is cyclically raised and lowered.

Fig. 3 shows a light emitting device in a double hetero structure using GaAs substrate 31 as the substrate composed of III-V group elements. In this light emitting element, an Sn-doped GaInP layer 32 is formed as a first layer of GaInP system mixed crystal on a GaAs substrate 31 by Sn solvent method, and multiple layers having double hetero junction, that is, AlGaInP cladding layer 33, GaInP (or AlGaInP, GaInPAs) active layer 34 and AlGaInP cladding layer 35 are sequentially grown epitaxially on the Sn-doped GaInP layer 32 as the second layer of GaInp system mixed crystal.

Fig. 4 shows a light emitting element in a single hetero structure using a GaAs substrate 41, in which an Sn-doped GaInP layer 42 is formed as a first layer on the GaAs substrate 41 by the Sn solvent method, and multiple layers having single hetero junction, that is, GaInP (or AlGaInP, GaInPAs) active layer 43 and AlGaInP cladding layer 44 are sequentially grown epitaxially on the Sn-doped GaInP layer 42 as the second layer.

The Sn solvent method employed in growth of GaInP system first layer on the GaAs substrate in the light emitting device in Figs. 3 and 4 is to prepare a solution by, for exmaple, adding Ga and InP or GaP and InP using Sn as the solvent, and grow this solution on the substrate by a known means. At this time, the contents of InP and GaP or Ga and InP to be added in the Sn soution should be adjusted, when obtaining an emission in yellow to green waves, so that the mixed crystal composition of the GaInP growth layer precipitating from the solution may be in a range of GaP molar fraction of 0.55 to 0.75. Since melt-back of GaAs substrate occurs when the growth solution is made by adding Ga and InP in the Sn solvent, it is preferable to grow the GaInP layer by the solution prepared by adding InP and GaP to the Sn solvent.

Precipitation of crystals of GaInP is effected, for example, as follows. That is, using Sn as metal solvent, and adding GaP and InP, the temperature is elevated up to the GaInP crystal growth temperature, and a metal solution containing four components, that is, Sn, In, P and Ga is pre pared. At this time, the content of each component is adjusted so that the solid solution of a desired composition is precipitated. Here, in the solution, III group elements of In and Ga are dissolved at a ratio so that the sum of the number of their atoms may be equal to the number of atoms of P which is V group element, that is, at a stoichiometrical ratio. In order to grow a GaInP mixed crystal containing GaP by molar fraction of 0.55 to 0.75 necessary for obtaining emission in yellow to green region, the ratio of InP and GaP dissolved in Sn solvent should be selected at a proper range of 3 to 40 mol% of GaP, assuming the total mol quantity of InP and GaP to be 100%.

When thus prepared solution is cooled in a state of contacting with GaAs seem crystal substrate at a slightly supercooled temperature, or when the temperature gradient is provided so that the temperature of the seed crystal substrate may be lower than the saturation temperature of the solution, the GaInP is supersaturated in the solution, and it is precipitated on the GaAs seed crystal substrate, and GaInP crystals are grown.

Thus obtained GaInP cyrstals contain few lattice defects. By using Sn as solvent, and dissolving InP and GaP in it, the solute in the solution is contained at a stoichiometric rate, that is, the III group element and V group element are contained at a ratio of 1 : 1 of the number of atoms, or at a nearly stoichiometric rate. This is because of the two reasons.

First, by using this growth solution, dissolution of the GaAs substrate is prevented. If GaAs should be dissolved in the Sn solution, since the chemical equivalent ratio of III group and V group is not changed, dissolution of traces of GaAs into this solution suddenly lowers the solubility of GaInP in this solution. That is, when the GaAs substrate is being dissolved, it lead to precipitation of GaInP, thereby preventing dissolution of GaAs. By contrast, the In-Ga-P solution generally used in growth of GaInP is a solution of non-stoichiometric ratio, and the solution composition is considerably shifted to the III group element excess side. Accordingly, if the In-Ga-P solution becomes a saturated solution at growth temperature, when this ternary solution contacts with GaAs, dissolution of GaAs occurs.

The second reason is that mismatching of the lattice constant existing between the GaAs substrate and GaInP growth layer can be lessened by the growth solution for dissolving InP and GaP in Sn solvent. This alleviating mechanism is not clarified at the present, but the two facts may be considered.

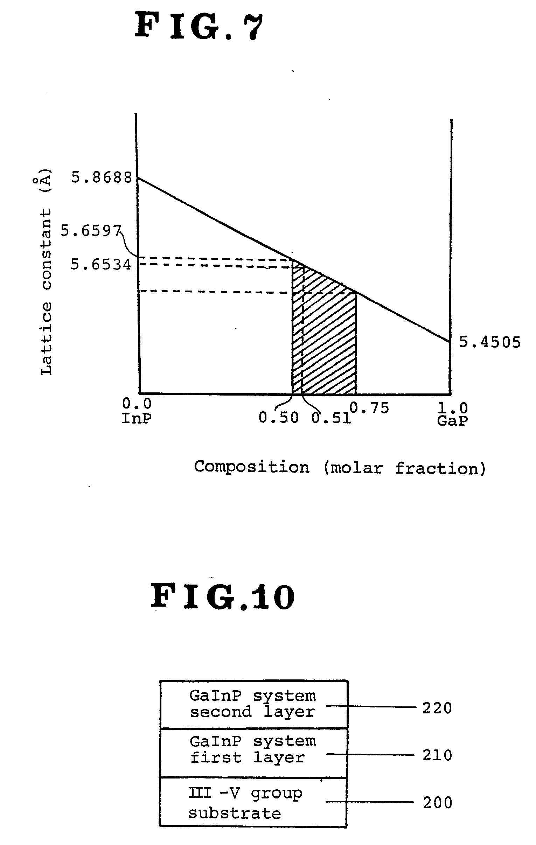

To discuss this alleviating mechanism, lattice mismatching is first explained by referring to the graph shown in Fig. 7. The lattice constant of InP is 5.8688 Å, and that of GaP is 5.4505 Å. Therefore, in the GaInP mixed crystal by blending InP and GaP, the lattice constant becomes an intermediate value of InP and GaP by the mixed crystal composition. On the other hand, the lattice constant of GaAs as substrate is 5.6534 Å, and supposing the molar fraction of GaP of mixed crystal composition of GaInP contained in this mixed crystal to be x, it coincides with the GaInP mixed crystal at x = 0.51. However, as clear from Fig. 7, in the mixed crystal composition range important as visible light emitting material, that is, in a range of x > 0.51, the lattice constant of the GaInP mixed crystal becomes smaller than that of GaAs, and lattice mismatching occurs.

As the mechanism of lessening this lattice mismatching, first, the impurity addition effect of Sn may be considered. This is practically explained below. III-V group compounds such as InP, GaP and GaAs, and GaInP mixed crystal have crystal structure of sphalerite type that is the zinc blende structure. According to the chemical bonding theory, the lattice constant depends on the distance between III group atom and V group atom, and the atom-to-atom distance nearly coincides with the sum of the tetrahedral type covalent bond radius (hereinafter abbreviated covalent bond radius) of each atom of III group and V group. Practical values of the covalence bond radius of elements relating to this invention is, according to page 224, Tables 7-13 of "The Nature of the Chemical Bond" (by L. Pauling, Cornell University Press, third edition, 1960), 1.10 Å for P, 1.18 Å for As, 1.26 Å for Ga, 1.44 Å for In and 1.40 Å for Sn. Therefore, the atom-to-atom distance is 2.54 Å for InP, 2.36 Å for GaP, and 2.44 Å for GaAs. In the GaInP mixed crystal, since In and Ga are mixed on the sub-lattice site of III group, the sum of the weighted mean of the covalent bond radius of Ga and In considering the composition ratio of the mixed crystal and the covalent bond radius of P is the mean atom-to-atom distance of this mixed crystal. On the other hand, Sn used as the solvent is a IV group element, and as an amphoteric impurity it can be replaced with the atom on the sub-lattice of either III group side or V group side of III-V group compound. Accordingly, when Sn is replaced by Ga on the Ga sub-lattice of GaP, the atom-to-atom distance increases from 2.36 Å of GaP to 2.50 Å which is the sum of the covalent bond radius of Sn and P. When P and Sn are placed on the P sub-lattice, the atom-to-atom distance is 2.66 Å. Therefore, when Sn is added to GaP, along with the increase of this atom-to-atom distance, the lattice constant of GaP increases. When Sn is added to InP, since the covalent bond radius 1.40 Å of Sn is not far smaller than 1.44 Å of In, when Sn is replaced with In on the In sub-lattice, the atom-to-atom distance decreases slightly. However, when Sn is replaced by P on the P sub-lattice, since the covalent bond radius of Sn is considerably larger than that of P, the atom-to-atom distance increases considerably. Therefore, in the case of InP, by the addition of Sn, the lattice constant increases. This fact is established also in GaInP which is a mixed crystal of InP and GaP, and accordingly, the lattice constant of GaInP increases by addition of Sn.

Thus, by adding Sn to GaInP mixed crystal, it may be understood that the lattice constant of GaInP mixed crystal increases. Next is described how the lattice mismatching existing between the GaAs substrate and GaInP growth layer is reduced by the Sn addition effect. The desired GaInP mixed crystal has a composition of x > 0.51 as mentioned above, and in this case the lattice constant of GaInP mixed crystal becomes smaller than that of GaAs. Accordingly, when growing GaInP of such mixed crystal composition on the GaAs substrate, a distortion due to lattice mismatching occurs at the interface of the two. However, the Sn in the growth solution is added automatically to GaInP so as to minimize the surface energy on this interface, and the lattice constant of GaInP is increased, thereby acting in the direction of decreasing this distortion, so that the lattice mismatching is lessened. As the growth of GaInP id advanced, the distortion decreases, and the addition of Sn decreases, finally reaching the stationary value. In other words, the initially grown GaInP layer behaves as a buffer layer having a gradient of lattice constant by the addition of Sn, which is regarded to lessen the lattice mismatching between the GaAs substrate and GaInP mixed crystal layer in the specified composition.

The following may be considered as the second relaxing mechanism of lattice mismatching between the GaAs substrate and GaInP growth layer obtained by addition of Sn.

First, in the initial phase of growth start, by the impurity effect of Sn, numerous GaInP insular fine crystals having the same orientation as the GaAs substrate are grown on the GaAs substrate. Originating from them, the islands are expanded as the growth in the lateral direction is promoted. Soon islands are connected mutually, and single-crystal GaInP growth layer is formed. Once the GaInP layer is formed in this way, the growth of GaInP layer continues, and an epitaxial growth layer of a specific thickness is obtained. Meanwhile, the lattice mismatching dislocation based on the mismatching of lattice constant between the GaAs substrate and GaInP growth layer is short-circuited at the interface between the GaAs substrate and GaInP growth layer, and propagation of the dislocation to the GaInP growth layer does not occur. Therefore, the obtained GaInP growth layer has a high quality.

As stated above, since the lattice mismatching is lessened at least by one of the first and second mechanisms, the GaInP growth layer of high quality is obtained.

After thus forming the GaInP first layer on the III-V group substrate, a second layer of GaInP system is formed by an suitable method selected from MOVPE, MBE and LPE.

As the method of the above LPE, aside from the ordinary method, the yo-yo solute feeding method employed in the formation of the first layer may be also used. In such a case, as the solution $103^{'}$ shown in Fig. 6, another solution same in composition as the solution $103^{'}$ but different only in conductive type should be prepared, and it should be used instead of the solution $103^{'}$ at a proper step of the temperature process shown in Fig. 5 (d), so that the second layer of a specified thickness may be formed.

In this invention, a p-n junction may be formed on the interface between the first layer and the second layer, or a double hetero junction or single hetero junction may be formed in the second layer. For example, a semiconductor light emitting device whose second layer is composed of multiple layers in double hetero structure as shown in Fig. 1 is manufactured by growing epitaxially AlGaInP cladding layer 13, GaInP active layer 14 and AlGaInP cladding layer 15 in this sequence on the GaInP layer 12 as the second layer.

In particular, the semiconductor light emitting device in hetero structure, whether in double hetero junction or single hetero junction, is ideal for LED and LD in the aspects of higher emitting efficiency as compared with homo junction. A surface light emitting device may be obtained by forming a p-n junction at the hetero junction part, or it may be also all right to form in an ordinary LD shape. Moreover, by diffusing the dopant which selectively becomes heteroconductive type, a light emitting region may be formed by diffused region and GaInP system active layer to obtain LED or LD, and in this case, substantially, a narrow light emitting region is formed, which is convenient for improvement of the current injection efficiency into the light emitting region, increase of emission brightness and high speed modulation. Examples of diffusion dopant may include S, Si, Te and Se as donor, and Ge, Be, Cd, Mg and Zn as acceptor.

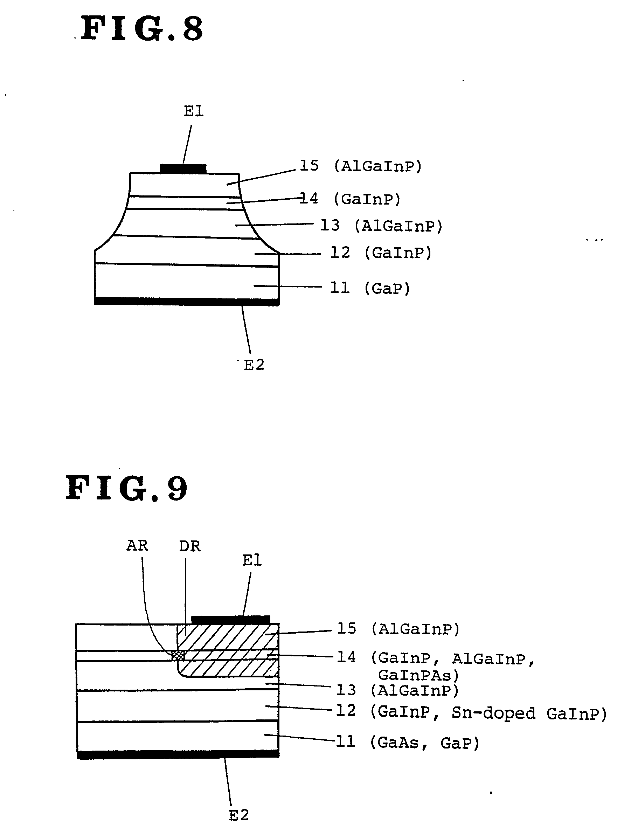

In the light emitting element in the double hetero structure using the GaP substrate shown in Fig. 1, when manufacturing, for example, a green LED, electrodes E1, E2 are disposed as shown in Fig. 8, and the structure may be similar to the high brightness LED in the ordinary double hetero structure, and the band gap of the GaInP active layer 14 may be set at 2.23 eV and the band gap of AlGaInP cladding layers 13, 15 may be set at 2.4 eV.

Or, as shown in Fig. 9, on the basis of the double hetero structure shown in Fig. 1 or Fig. 3, by diffusing a dopant of a different conductive type from the multiple layers to compose the second layer (that is, when the conductive type of the GaInP active layer is p-type, it is a donor, and when it is n-type, it is an acceptor), an emission region AR may be formed by diffusion region DR and GaInP active layer, and the p-side electrode materials and n-side electrode materials E1, E2 may be formed by vacuum deposition or similar means. The light may be taken out either from the edge or from the face direction. For fabricating LD of short wavelength, by further cleaving the materials, a stripe-shaped active region may be built in a cavity structure.

In particular, the light emitting element built in the structure shown in Fig. 8 has a double hetero junction, and the light emitting element in the structure shown in Fig. 9 has a double hetero junction and also a narrow emission region, and the emission is further enhanced in brightness, and it can be applied in diversified uses.

Furthermore, the LD in the structure shown in Fig. 9 contains GaInP (or AlGaInP, GaInPAs) which has the largest direct transition type band gap and is most advantageous for shortening of wavelength, and by utilizing these features, short wavelengths in visible region of green to yellow waves are obtained, and it is useful for enhancing the performance of the optical information processing system, such as high density of optical disk memory and video disk, and high speed operation of laser printer. Besides, the visible light LD in green to yellow waves involves a possibility of new applications, not found in the hitherto infrared oscillating LD, as the small and lightweight light source for emitting coherent light visible to the naked eye.

The semiconductor light emitting device of this invention is thus composed, and short wavelength emissions are obtained in the structure comprising, as shown in Fig. 10, a III-V group substrate, a first layer of GaInP system mixed crystal and a second layer of GaInP system mixed crystal.

In the semiconductor light emitting device, whether the GaP substrate or the GaAs substrate is used as the III-V group substrate as shown in the embodiments, an LED in green to yellow band wavelength may be easily obtained by dopant control during crystal growth, or by forming p-n junction by diffusion and installing p-side electrode and n-side electrode. Besides, for example as shown in Fig. 9, by forming a cavity by cleaving the constituent materials, visible light LD in green to yellow band short wavelength may be obtained easily.

## Claims

1. A semiconductor light emitting device comprising a substrate composed of III-V group elements, a first layer mainly composed of GaInP formed on the III-V group substrate by the yo-yo solute feeding method or Sn solvent method, and a second layer mainly composed of GaInP formed on the first layer by a method selected from MOVPE, MBE and LPE.

2. A semiconductor light emitting device according to claim 1, wherein the III-V group substrate is composed of GaP, the first layer is composed of GaInP formed by the yo-yo solute feeding method, and the second layer is composed of an AlGaInP cladding layer, a GaInP with or without active layer Al or GaInPAs active layer, and an AlGaInP cladding layer, in a double hetero structure.

3. A semiconductor light emitting device according to claim 1, wherein the III-V group substrate is composed of GaP, the first layer is composed of GaInP formed by the yo-yo solute feeding method, and the second layer is composed of a GaInP active layer with or without Al or GaInPAs active layer, and an AlGaInP cladding layer, in a single hetero structure.

4. A semiconductor light emitting device according to claim 1, wherein the III-V group substrate is composed of GaAs, the first layer is composed of an Sn-doped GaInP formed by the Sn solvent method, and the second layer is composed of an AlGaInP cladding layer, a GaInP active layer with or without Al or GaInPAs active layer, and an AlGaInP cladding layer, in a double hetero structure.

5. A semiconductor light emitting device according to claim 1, wherein the III-V group substrate is composed of GaAs, the first layer is composed of an Sn-doped GaInP formed by the Sn solvent method, and the second layer is composed of a GaInP active layer with or without Al or GaInPAs active layer, and an AlGaInP cladding layer, in a single hetero structure.

6. A semiconductor light emitting device according to claim 1, wherein the yo-yo solute feeding method is used as the LPE for forming the second layer.

# FIG.1

| Second layer { | Cladding layer | — 15 (AlGaInP) |
| | Active layer | — 14 (GaInP, AlGaInP, GaInPAs) |
| | Cladding layer | — 13 (AlGaInP) |
| | First layer | — 12 (GaInP) |
| | Substrate | — 11 (GaP) |

# FIG.2

| Second layer { | Cladding layer | — 24 (AlGaInP) |
| | Active layer | — 23 (GaInP, AlGaInP, GaInPAs) |
| | First layer | — 22 (GaInP) |
| | Substrate | — 21 (GaP) |

# FIG. 3

Second layer {
Cladding layer — 35 (AlGaInP)
Active layer — 34 (GaInP, AlGaInP, GaInPAs)
Cladding layer — 33 (AlGaInP)
First layer — 32 (Sn-doped GaInP)
Substrate — 31 (GaAs)

# FIG. 4

Second layer {
Cladding layer — 44 (AlGaInP)
Active layer — 43 (GaInP, AlGaInP, GaInPAs)
First layer — 42 (Sn-doped GaInP)
Substrate — 41 (GaAs)

# FIG.5

GaP substrate — 71

g ↓

Solution — 73

GaInP alloy — 72

(a)

GaP substrate — 71

Solution — 73 — 74

GaInP alloy — 72

(b)

GaP substrate — 71 — 74 — 75

Solution — 73

GaInP alloy — 72

(c)

(d)

# FIG.5

(e)

# FIG.6

# FIG.7

Composition (molar fraction)

# FIG.10

| GaInP system second layer | 220 |
| GaInP system first layer | 210 |
| III-V group substrate | 200 |

# FIG.8

E1

15 (AlGaInP)

14 (GaInP)

13 (AlGaInP)

12 (GaInP)

11 (GaP)

E2

# FIG.9

AR    DR    E1

15 (AlGaInP)

14 (GaInP, AlGaInP, GaInPAs)

13 (AlGaInP)

12 (GaInP, Sn-doped GaInP)

11 (GaAs, GaP)

E2